# EUROPÄISCHE PATENTANMELDUNG

(11) **EP 3 029 838 A1**
(43) Veröffentlichungstag der Anmeldung: **08.06.2016**
(21) Anmeldenummer: 14004103.9
(22) Anmeldetag: 04.12.2014
(51) Int. Cl.: H03K 17/96

(54) **Sensoreinrichtung**

(71) Anmelder: FESTO AG & Co. KG, 73734 Esslingen (DE)
(72) Erfinder: Siebel, Andreas, 72639 Neuffen (DE); Konold, Johannes, 70597 Stuttgart (DE)
(74) Vertreter: Patentanwälte Magenbauer & Kollegen Partnerschaft mbB

(57) **Zusammenfassung**

Die Erfindung betrifft eine Sensoreinrichtung für eine Erfassung von manuellen Benutzereingaben, mit einem Sensorgehäuse (2, 4; 42, 44), das an einer Außenoberfläche zumindest bereichsweise als Bedienoberfläche (13; 53) ausgebildet ist und das ein Raumvolumen (14; 54) umschließt, in dem eine elektronische Schaltung (5; 45) zur kapazitiven Erfassung einer manuellen Benutzereingabe aufgenommen ist, die elektrisch mit wenigstens einer elektrisch leitend ausgebildeten Sensorfläche (36; 76) verbunden ist und die beabstandet zur Bedienoberfläche (13; 53) angeordnet ist. Erfindungsgemäß ist vorgesehen, dass die Sensorfläche (36; 76) an einem quer zwischen der elektronischen Schaltung (4; 45) und der Bedienoberfläche (13; 53) erstreckten Trennelement (3; 43) ausgebildet ist.

## Beschreibung

Die Erfindung betrifft eine Sensoreinrichtung für eine Erfassung von manuellen Benutzereingaben, mit einem Sensorgehäuse, das an einer Außenoberfläche zumindest bereichsweise als Bedienoberfläche ausgebildet ist und das ein Raumvolumen umschließt, in dem eine elektronische Schaltung zur kapazitiven Erfassung einer manuellen Benutzereingabe aufgenommen ist, die elektrisch mit wenigstens einer elektrisch leitend ausgebildeten Sensorfläche verbunden ist und die beabstandet zur Bedienoberfläche angeordnet ist.

Derartige Sensoreinrichtungen sind beispielsweise aus dem Bereich der elektrischen Glaskeramikkochfelder für den Haushaltsgebrauch bekannt, bei denen eine Eingabe von Bedienwünschen durch das elektrisch nicht leitende Glaskeramikkochfeld hindurch vorgenommen werden kann. Hierzu ist unterhalb des Glaskeramikkochfelds eine elektronische Schaltung angeordnet, die eine Erfassung einer manuellen Benutzereingabe, beispielsweise durch Annäherung eines Fingers oder einer Handfläche, in kapazitiver Weise ermöglicht. Diese Schaltung umfasst eine erste Kondensatorplatte, die parallel zur größten Oberfläche des Glaskeramikkochfelds unmittelbar unterhalb der Bedienoberfläche angeordnet wird, sowie eine mit der ersten Kondensatorplatte verbundene Auswerteschaltung. Ein Benutzer stellt bei dieser Schaltung eine zweite Kondensatorplatte dar. In Abhängigkeit von einer Annäherung des Benutzers an die erste Kondensatorplatte wird eine Kapazität des durch die erste Kondensatorplatte und den Benutzer gebildeten Kondensators beeinflusst, wobei diese Kapazität durch die Auswerteschaltung ermittelt wird, um daraus Rückschlüsse auf einen Bedienwunsch des Benutzers zu ermöglichen. Vorzugsweise ist der erste Kondensator in Form eines elektrisch leitenden Folienabschnitts ausgebildet, der in elektrischer Verbindung mit der Auswerteschaltung steht.

Aus der DE 10 2007 004 889 B4 ist ein kapazitiver Inkrementalgeber mit zumindest drei Gruppen von einzelnen Sensorflächen bekannt, wobei alle Sensorflächen derselben Gruppe miteinander elektrisch leitend verbunden sind, wobei die Sensorflächen von einer elektrisch isolierenden Abdeckplatte abgedeckt sind und Teile von Kondensatoren mit durch Berührung der Abdeckplatte veränderlicher Kapazität sind, wobei jeweils zwischen zwei Sensorflächen derselben Gruppe je eine Sensorfläche von jeder der anderen Gruppen angeordnet ist. Jede Gruppe ist derart mit einer Spannungsquelle verbunden, so dass an jede Gruppe ein Spannungseingangssignal anlegbar ist, und jede Gruppe ist derart mit einer Auswerteschaltung verbunden, so dass für jede Gruppe je ein Ausgangssignal auswertbar ist.

Die Aufgabe der Erfindung besteht darin, eine Sensoreinrichtung bereitzustellen, die eine besonders kompakte Bauweise aufweist.

Diese Aufgabe wird für eine Sensoreinrichtung der eingangs genannten Art mit den Merkmalen des Anspruchs 1 gelöst.

Hierbei ist vorgesehen, dass die Sensorfläche an einem quer zwischen der elektronischen Schaltung und der Bedienoberfläche erstreckten Trennelement ausgebildet ist. Bei dem eingangs angeführten, vorbekannten Stand der Technik ist unmittelbar unterhalb eines Glaskeramikkochfelds eine parallel zum Glaskeramikkochfeld ausgerichtete Sensorfläche vorgesehen. Abweichend hiervon wird bei der nunmehr vorgeschlagenen Sensoreinrichtung eine Ausrichtung der Sensorfläche angestrebt, bei der eine Flächennormale der Sensorfläche zumindest im wesentlichen quer bzw. orthogonal zu einer Achse ausgerichtet ist, die durch den Abstand zwischen der elektronischen Schaltung und der Bedienoberfläche bestimmt wird. Dadurch ist die Sensorfläche zumindest im Wesentlichen quer zur elektronischen Schaltung und/oder zur Bedienoberfläche ausgerichtet. Durch eine derartige Ausrichtung der Sensorfläche kann insbesondere erreicht werden, dass ein optischer Pfad für Lichtstrahlen, die von einem auf der elektronischen Schaltung angeordneten Leuchtmittel in Richtung der Bedienoberfläche ausgesendet werden sollen, weniger als beim vorbekannten Stand der Technik, insbesondere nahezu gar nicht, durch die Sensorfläche behindert wird, so dass eine vorteilhafte Ausleuchtung oder Hinterleuchtung der Bedienoberfläche ermöglicht wird. Ergänzend zu der wenigstens einen Sensorfläche kann wenigstens eine Spule vorgesehen sein, die ebenfalls mit der elektronischen Schaltung verbunden ist und die für eine kontaktlose Nahfeldkommunikation mit einem mobilen Endgerät, beispielsweise einem Mobiltelefon, ausgebildet ist. Mit einer derartigen Nahfeldkommunikation kann beispielsweise eine drahtlose Programmierung und/oder Parametrierung der Sensoreinrichtung vorgenommen werden. Ergänzend oder alternativ können auch Parameter, die in der elektronischen Schaltung gespeichert sind, über elektromagnetische Wellen, die von der Spule durch geeignete Ansteuerung von der elektronischen Schaltung ausgesendet werden, an das mobile Endgerät übertragen werden.

Vorteilhafte Weiterbildungen der Erfindung sind in den Unteransprüchen angegeben.

Zweckmäßig ist es, wenn das Trennelement für eine Aufteilung des Raumvolumens in wenigstens zwei Teilräume ausgebildet ist und wenn in wenigstens einem der Teilräume ein der elektronischen Schaltung zugeordnetes Leuchtmittel angeordnet ist. Vorzugsweise werden die beiden Teilräume des Raumvolumens durch das Trennelement in solcher Weise voneinander getrennt, dass bei einem Betrieb des Leuchtmittels, das dem einen Teilraum zugeordnet ist, keine oder zumindest nahezu keine Lichtstrahlen in den zweiten Teilraum eindringen, so dass dieser für einen Benutzer eine andere Wahrnehmung ermöglicht als der vom jeweils zugeordneten Leuchtmittel beleuchtete Teilraum.

In weiterer Ausgestaltung der Erfindung ist vorgesehen, dass das Trennelement gestaltfest ausgebildet ist und/oder zumindest nahezu lichtundurchlässig für Lichtstrahlen des Leuchtmittels ausgeführt ist. Bei einer gestaltfesten Ausbildung des Trennelements kann dieses ohne zusätzliche Abstützmaßnahmen als separate Baugruppe in dem Sensorgehäuse eingebaut werden, wodurch die Herstellung einer derartigen Sensoreinrichtung vereinfacht wird. Eine zumindest nahezu vollständige Lichtundurchlässigkeit für Lichtstrahlen des Leuchtmittels gewährleistet bei einem Betrieb der Sensoreinrichtung eine gute optische Unterscheidbarkeit der wenigstens zwei Teilräume, die durch das Trennelement im Raumvolumen geschaffen werden und von denen wenigstens einer mit einem Leuchtmittel beleuchtet wird. Somit wird für einen Benutzer eine Erkennung eines Betriebszustandes der Sensoreinrichtung oder einer mit der Sensoreinrichtung gekoppelten Vorrichtung wie beispielsweise einem Aktor, die durch geeignete Beleuchtung der jeweiligen Teilräume visualisiert werden soll, zuverlässig ermöglicht.

Vorteilhaft ist es, wenn die wenigstens eine Sensorfläche stoffschlüssig am Trennelement angebracht ist. Vorzugsweise ist die Sensorfläche als selbstklebende, elektrisch leitende Folie ausgebildet und auf die Oberfläche des Trennelements aufgeklebt. Alternativ kann vorgesehen sein, das Trennelement zumindest bereichsweise mit einer elektrisch leitenden Beschichtung, insbesondere durch Bedampfung mit einer metallischen Schicht, zu versehen. Eine weitere Alternative sieht vor, das Trennelement im sogenannten MID-Verfahren (Molded Interconect Devices-Verfahren), insbesondere im Zweikomponenten-Spritzgussverfahren herzustellen, wobei hier ein Kunststoffteil bereichsweise mit elektrisch leitenden Strukturen versehen wird, die stoffschlüssig an dem Trägermaterial aufgebracht werden.

Bevorzugt ist vorgesehen, dass die elektronische Schaltung wenigstens ein Kontaktmittel, insbesondere eine Kontaktfeder umfasst, die für eine kombinierte elektrische und mechanische Kopplung des mit der Sensorfläche versehenen Trennelements ausgebildet ist. Vorzugsweise ermöglicht ein solches Kontaktmittel ein einfaches Aufstecken des Trennelements auf die elektronische Schaltung, wobei im Zuge dieses Steckvorgangs sowohl die mechanische als auch die elektrische Kontaktierung bzw. Kopplung zwischen elektronischer Schaltung und Trennelement verwirklicht wird. Exemplarisch kann das Kontaktmittel als U-förmige, metallische Kontaktfeder ausgebildet sein, bei der ein Verbindungssteg zwischen den beiden U-Schenkeln an der elektronischen Schaltung festgelegt ist. Ferner sind die U-Schenkel federelastisch ausgebildet und ermöglichen ein kraftschlüssiges Festlegen und ein elektrisches Kontaktieren der Sensorflächen des Trennelements an der elektronischen Schaltung.

Bei einer vorteilhaften Weiterbildung der Erfindung ist vorgesehen, dass die elektronische Schaltung einen als Sensorfläche ausgebildeten, einstückig angeformten und am Trennelement festgelegten Schaltungsabschnitt aufweist. Bei einer solchen Ausführung der elektronischen Schaltung, insbesondere als zumindest bereichsweise flexible elektronische Leiterplatte, kann vollständig auf eine zusätzliche Herstellung von elektrischen Verbindungen zwischen der Sensorfläche und der elektronischen Schaltung verzichtet werden, wodurch Kontaktschwierigkeiten zwischen elektronischer Schaltung und Sensorfläche vermieden werden. Exemplarisch ist vorgesehen, dass wenigstens ein flexibel von der elektronischen Schaltung abwinkelbarer Schaltungsabschnitt an dem quer zur elektronischen Schaltung ausgerichteten Trennelement festgelegt wird und hierbei die Sensorfläche für die kapazitive Erfassung einer manuellen Benutzereingabe bildet. Dabei kann der Schaltungsabschnitt stoffschlüssig und/oder formschlüssig und/oder kraftschlüssig am Trennelement festgelegt werden.

Zweckmäßig ist es, wenn das Trennelement eine Lichtleithülse umfasst und wenn an der Lichtleithülse mehrere Trennwände angeordnet sind, die sich ausgehend von einer Mittelachse, insbesondere einer Symmetrieachse, der Lichtleithülse in radialer Richtung nach außen bis zum Sensorgehäuse erstrecken, wobei die Lichtleithülse und die Trennwände jeweils Teilräume des Raumvolumens voneinander trennen und wobei zumindest einem der Teilräume ein Leuchtmittel auf der elektronischen Schaltung zugeordnet ist. Hierbei ist besonders vorteilhaft, wenn die Lichtleithülse und/oder zumindest einige der Trennwände, insbesondere sämtliche der Trennwände, jeweils bis zu einem körperlichen Kontakt mit einer Innenoberfläche des Sensorgehäuses geführt sind, um ein Übertreten von Lichtstrahlen aus den jeweils benachbarten Teilräumen zu verhindern und somit eine scharfe Unterscheidung von unterschiedlichen Leuchtzuständen der jeweiligen Leuchtmittel durch den Benutzer zu ermöglichen. Dies ist insbesondere dann von Interesse, wenn mit Hilfe der Sensoreinrichtung unterschiedliche Benutzereingaben ermöglicht werden sollen, die durch Annäherung einer Hand oder eines Fingers des Benutzers an unterschiedliche Bereiche der Sensoreinrichtung detektiert werden sollen und die vorzugsweise durch entsprechende Lichtsignale der Leuchtmittel quittiert werden sollen, so dass der Benutzer eine Information darüber erhält, ob der von ihm vorgesehene Bedienvorgang erfolgreich abgeschlossen werden konnte.

Bevorzugt ist vorgesehen, dass an der Lichtleithülse und/oder an wenigstens einer der Trennwände eine Sensorfläche ausgebildet und/oder eine Spule angeordnet ist. Hierdurch kommt dem vorzugsweise aus der Lichtleithülse und der wenigstens einen zugeordneten Trennwand ausgebildeten Trennelement eine Doppelfunktion zu. Zum einen dient das Trennelement zur Abtrennung der Teilräume, um eine Beleuchtungen von unterschiedlichen Bereichen des Sensorgehäuses zu ermöglichen. Zum anderen dienen die Lichtleithülse und die wenigstens eine Trennwand zumindest bereichsweise als Sensorflächen zur Erfassung von Bedienwünschen eines Benutzers oder Träger für eine oder mehrere Spulen, die für eine Nahfeldkommunikation mit einem mobilen Endgerät ausgebildet sind.

In weiterer Ausgestaltung der Erfindung ist vorgesehen, dass das Trennelement längs einer Profilachse eine, insbesondere zumindest nahezu konstante, Profilierung aufweist. Bei einer derartigen Gestaltung des Trennelements ist eine Herstellung in einem Kunststoffspritzgussverfahren oder einem Strangpressverfahren zu geringen Herstellungskosten durchführbar. Dabei ist die Profilachse derart ausgerichtet, dass Querschnitte des Trennelements, also der Lichtleithülse und der wenigstens einen Trennwand, in zueinander parallelen und normal zur Profilachse ausgerichteten Querschnittsebenen stets konstant sind. Bei einer Ausgestaltung des Trennelements als Kunststoffspritzgussteil können stabilisierende Stegverbindungen zwischen benachbarten Trennwänden vorgesehen sein, ohne dass hierdurch die Herstellbarkeit des Trennelements im Kunststoffspritzgussverfahren in Frage gestellt wird.

Vorteilhaft ist es, wenn das Trennelement mit einem Endbereich an eine schräg zur Profilachse ausgerichtete, insbesondere gekrümmt ausgebildete, Innenoberfläche der Bedienoberfläche angrenzt. Eine derartige Abschrägung des Sensorgehäuses und die daraus resultierende schräg zur Profilachse ausgerichtete Bedienoberfläche, die insbesondere aus einem transparenten oder transluzenten Material hergestellt ist, ermöglichen eine besonders gute Sichtbarkeit der einzelnen in den jeweiligen Teilräumen aufgenommenen Leuchtmittel. Somit ist auch bei einer ungünstigen räumlichen Anordnung der Sensoreinrichtung an einem Aktor oder einer sonstigen Maschinenkomponente eine vorteilhafte Sichtbarkeit der von der Sensoreinrichtung zur Verfügung zu stellenden Leuchtinformationen gewährleistet. Besonders vorteilhaft ist es, wenn die Bedienoberfläche eine Krümmung in wenigstens einer Raumrichtung, insbesondere eine sphärische Krümmung in zwei zueinander senkrechten Raumrichtungen aufweist, da hierdurch die Sichtbarkeit der Leuchtmittel unterhalb der Bedienoberfläche weiter verbessert werden kann.

Bevorzugt ist vorgesehen, dass Leuchtmittel im Raumvolumen angeordnet sind, die auf einer, vorzugsweise eben ausgebildeten, gemeinsamen elektrischen Leiteranordnung, insbesondere einer Leiterplatte oder einer flexiblen Leiterfolie, angebracht sind. Bei der Leiterplatte oder der flexiblen Leiterfolie handelt es sich um eine sogenannte gedruckte Schaltung, bei der elektrisch leitende Bahnen auf einem isolierenden Substrat, insbesondere einer faserverstärkten Kunststoffplatte oder einer flexiblen Folie aufgebracht sind. Durch diese elektrische Leiteranordnung wird eine vorteilhafte und kostengünstige elektrische Kontaktierung der Leuchtmittel ermöglicht. Bei einer Verwendung einer Leiterplatte ist es vorteilhaft, wenn die Leuchtmittel in einer gemeinsamen Bestückungsebene, die durch eine Oberfläche der Leiterplatte bestimmt wird, angeordnet, insbesondere aufgelötet, sind. Bei einer Verwendung einer flexiblen Leiterfolie findet zwar eine Bestückung der Leuchtmittel, bei denen es sich beispielsweise um Leuchtdioden handeln kann, vorzugsweise in einer gemeinsamen Bestückungsebene statt. Anschließend kann jedoch bei der Montage der flexiblen Leiterfolie in das vorzugsweise zweiteilig ausgebildete Sensorgehäuse bzw. an die Lichtleithülse und/oder die wenigstens eine Trennwand eine Abwinklung von Teilbereichen der flexiblen Leiterfolie vorgesehen werden, um eine besonders vorteilhafte Ausrichtung der in diesen Teilbereichen angeordneten Leuchtmittel relativ zur Lichtleithülse bzw. zu der wenigstens einen Trennwand zu gewährleisten.

Bevorzugt ist vorgesehen, dass die Leuchtmittel zusammen mit der Leiteranordnung zugeordneten elektronischen Komponenten eine elektronische Schaltung bilden, die für eine gezielte Ansteuerung der Leuchtmittel in Abhängigkeit von einer Benutzereingabe an wenigstens einer Sensorfläche ausgebildet sind. Beispielsweise kann auf der Leiteranordnung ein Mikrocontroller oder Mikroprozessor angeordnet sein, der insbesondere zum Empfang eines Sensorsignals von wenigstens einer der Sensorflächen ausgebildet ist und der das empfangene Sensorsignal verarbeiten kann, um beispielsweise eine Ausgabe von unterschiedlichen, gemäß einer vorgebbaren Kodierung ausgewählten, Leuchtsignalen durch die jeweiligen Leuchtmittel und/oder einer Weiterleitung des Sensorsignals an andere elektrisch mit der Sensoreinrichtung verbundene Steuerungskomponenten oder Maschinenelemente zu ermöglichen. Ferner soll mit Hilfe der elektronischen Schaltung eine optische Rückmeldung an den Benutzer gegeben werden, sobald dieser eine erfolgreiche Benutzereingabe getätigt hat. Dies kann beispielsweise durch Aufleuchten oder Erlöschen eines jeweils zugeordneten Leuchtmittels oder durch Änderung der Helligkeit oder Farbe des jeweiligen Leuchtmittels erreicht werden. Bevorzugt ist eine getrennte Auswertung der einzelnen Sensorflächen durch den Mikroprozessor oder Mikrocontroller vorgesehen, so dass mehrere unterschiedliche Sensorbereiche, möglicherweise auch an mehreren, räumlich voneinander beabstandeten Bedienoberflächen des Sensorgehäuses, gebildet werden, die unterschiedliche Eingaben des Benutzers ermöglichen.

Besonders vorteilhaft ist es, wenn die elektronische Schaltung für eine Ansteuerung der Leuchtmittel nach vorgebbaren Mustern, insbesondere in der Art einer Segmentanzeige, ausgebildet ist und/oder wenn zumindest eines der Leuchtmittel für eine vorgebbare Abgabe von verschieden farbigen Lichtstrahlen ausgebildet ist. Hierfür kann vorgesehen sein, die elektronische Schaltung, die insbesondere einen Mikrocontroller oder Mikroprozessor umfasst, in geeigneter Weise, gegebenenfalls auch durch einen Benutzer veränderlich, zu programmieren, um die Sensorsignale der einzelnen Sensorflächen, die von der elektronischen Schaltung ermittelt und verarbeitet werden, in eine geeignete Kodierung der Leuchtsignale umzusetzen. Diese Kodierung kann dann durch entsprechende Ansteuerung der jeweiligen Leuchtmittel für einen Benutzer visualisiert werden, beispielsweise um eine ermittelte Benutzereingabe der Sensoreinrichtung optisch darzustellen. Besonders vorteilhaft ist es, wenn in Abhängigkeit von einem Zustand des mit der Sensoreinrichtung ausgerüsteten Aktors eine linienförmige, insbesondere kreisförmige, Anordnung von Leuchtmitteln, die in entsprechenden Teilräumen aufgenommen sind, dazu eingesetzt wird, einen Zustand der Sensoreinrichtung oder einer mit der Sensoreinrichtung verbundenen Maschinenkomponente, insbesondere des Aktors, zu visualisieren. Alternativ kann vorgesehen sein, dass die Leuchtmittel derart durch die elektronische Schaltung angesteuert werden, dass Ziffern oder alphanummerische Zeichen mit Hilfe der jeweiligen Leuchtmittel dargestellt werden. Ergänzend oder alternativ kann vorgesehen werden, dass wenigstens eines der Leuchtmittel als Mehrfarb-Leuchtdiode ausgebildet ist, wobei durch geeignete Ansteuerung dieser Mehrfarb-Leuchtdiode Lichtstrahlen in unterschiedlichen Farben selektiv abgegeben werden können. Beispielsweise kann das Leuchtmittel dazu eingerichtet sein, wahlweise rote, gelbe oder blaue Lichtstrahlen oder durch vorzugsweise frei wählbare Mischung, farbige Lichtstrahlen abzugeben.

In weiterer Ausgestaltung der Erfindung ist vorgesehen, dass die elektronische Schaltung für eine kapazitive Nahfeldkommunikation mit einer benutzergeführten Aktivierungseinheit ausgebildet ist. Bei der benutzergeführten Aktivierungseinheit handelt es sich um eine elektronische Schaltung, die von einem Benutzer beispielsweise in Form eines Armbandes oder Schlüsselanhängers getragen wird und die für einen Informationsaustausch mit der elektronischen Schaltung über die kapazitive Kopplung mittels der Sensorflächen vorgesehen ist. Beispielsweise kann vorgesehen sein, dass die Aktivierungseinheit eine Modulation der Kondensatorkapazität vornimmt, die von der elektronischen Schaltung erfasst wird, um darüber festzustellen, ob der Benutzer berechtigt ist, die gewünschte Einstellung vorzunehmen. Somit ermöglicht die benutzergeführte Aktivierungseinheit in direktem räumlichen Zusammenhang mit der Sensoreinrichtung, insbesondere ohne die Notwendigkeit zur Bereitstellung eines zusätzlichen Kommunikationskanals wie beispielsweise Bluetooth oder ZigBee, zum Nachweis einer Berechtigung für die Einflussnahme auf die Sensoreinrichtung. Dies kann insbesondere bei größeren Anlagen von Interesse sein, bei denen eine Vielzahl derartiger Sensoreinrichtungen vorgesehen ist und bei denen ein unbefugtes Betätigen der Sensoreinrichtungen und der möglicherweise zugeordneten Maschinenkomponenten verhindert werden soll.

Vorteilhaft ist es, wenn die Sensorfläche zumindest im Wesentlichen quer zu einer Haupterstreckungsebene der elektronischen Schaltung und/oder zumindest im Wesentlichen quer zu einer Haupterstreckungsebene der Bedienoberfläche ausgebildet ist. Für eine besonders kompakte Aufbauweise der Sensoreinrichtung ist vorzusehen, dass eine auch als Haupterstreckungsebene bezeichnete größte Oberfläche der elektronischen Schaltung und eine auch als Haupterstreckungsebene bezeichnete größte Oberfläche der Bedienoberfläche zumindest im wesentlichen parallel zueinander ausgerichtet sind und dass die wenigstens eine Sensorfläche quer zu diesen Haupterstreckungsebenen ausgerichtet ist.

Vorteilhafte Weiterbildungen der Erfindung sind in der Zeichnung dargestellt. Hierbei zeigt:
- Figur 1: eine perspektivische Explosionsdarstellung einer Sensoreinrichtung mit einem napfförmig ausgebildeten Träger, einer in diesem Träger aufgenommenen, mit Leuchtmitteln ausgestatteten elektronischen Schaltung, einem mit mehreren Sensorflächen versehenen Trennelement sowie einer Abdeckung,
- Figur 2: eine schematisierte Draufsicht auf die Sensoreinrichtung gemäß der Figur 1,
- Figur 3: eine schematisierte Draufsicht auf die elektronische Schaltung gemäß den Figuren 1 und 2,
- Figur 4: eine schematisierte Draufsicht auf eine zweite Ausführungsform einer Sensoreinrichtung mit einem im Wesentlichen quadratischen Querschnitt und mit Leuchtmitteln, die zumindest teilweise an der Lichtleithülse angeordnet sind sowie mit mehreren Sensorflächen,
- Figur 5: eine schematisierte Draufsicht auf die zur Verwendung in der Sensoreinrichtung gemäß Figur 4 vorgesehene elektronische Schaltung, die als flexible Leiterfolie ausgebildet ist,
- Figur 6: eine Seitenansicht der zweiten Ausführungsform der Sensoreinrichtung gemäß der Figur 4,
- Figur 7: eine perspektivische Darstellung eines Aktors, der mit einer Sensoreinrichtung gemäß der ersten Ausführungsform ausgestattet ist, wobei eine erste Anzeigekonfiguration vorliegt, und
- Figur 8: der Aktor gemäß der Figur 7 in einer zweiten Anzeigekonfiguration.

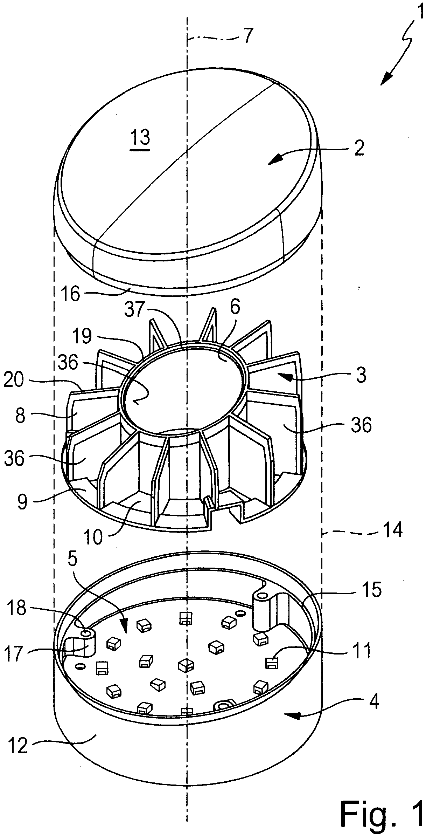

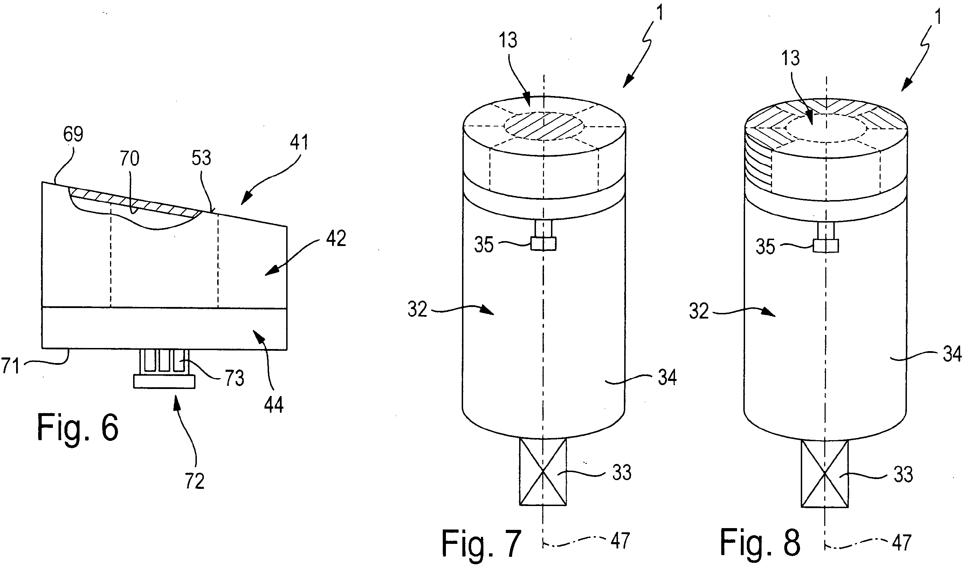

Eine erste Ausführungsform einer Sensoreinrichtung 1 sowie die wesentlichen Komponenten dieser Sensoreinrichtung 1 sind schematisch in den Figuren 1 bis 3 dargestellt. Die Sensoreinrichtung 1 ist zur Anbringung an einem Aktor 32 vorgesehen wie dies in den Figuren 7 und 8 näher dargestellt wird. Bei dem Aktor 32 handelt es sich exemplarisch um einen elektrischen Drehantrieb, es könnte sich jedoch auch um fluidischen oder elektrischen Linearantrieb wie einen Pneumatikzylinder oder einen Linearmotor oder um einen fluidischen, insbesondere pneumatischen oder hydraulischen Drehantrieb handeln.

Die in der Figur 1 näher dargestellte Sensoreinrichtung 1 umfasst eine Abdeckung 2, ein Trennelement 3, einen napfförmigen Träger 4 sowie eine im napfförmigen Träger 4 aufgenommene elektronische Schaltung 5. Dabei ist das Trennelement 3 für eine bereichsweise Aufnahme in dem napfförmigen Träger 4 vorgesehen und wird in einem schematisch in den Figuren 7 und 8 dargestellten Montagezustand der Sensoreinrichtung 1 vollständig von dem Träger 4 und der ebenfalls napfförmig ausgebildeten Abdeckung 2 umfasst.

Exemplarisch ist vorgesehen, dass die Abdeckung 2 aus einem transluzenten Kunststoffmaterial hergestellt ist und vorzugsweise an einer nicht näher dargestellten Innenoberfläche mit einer milchglasartigen Aufrauhung versehen ist, um eine vorteilhafte Streuung von Lichtstrahlen, die aus dem Inneren der Sensoreinrichtung 1 von Leuchtmitteln bereitgestellt werden, zu bewirken. An einer exemplarisch gekrümmt ausgebildeten Bedienoberfläche 13 der Abdeckung sind nachstehend näher beschriebene Bedienbereiche ausgebildet, die eine selektive Eingabe von Benutzerwünschen an der Sensoreinrichtung 1 ermöglichen.

Der Träger 4 ist exemplarisch ebenfalls aus einem Kunststoffmaterial, insbesondere im Kunststoffspritzgussverfahren, hergestellt und weist im Gegensatz zur Abdeckung 2 eine verschwindende Lichtdurchlässigkeit auf. Das Trennelement 3 ist beispielhaft ebenfalls aus einem Kunststoffmaterial, insbesondere im Kunststoffspritzgussverfahren, hergestellt und umfasst eine zentrale, beispielhaft kreiszylindrisch ausgebildete, Lichtleithülse 6 sowie strahlenförmig in radialer Richtung ausgehend von einer Mittelachse 7 der Lichtleithülse 6 erstreckte Trennwände 8. Vorzugsweise sind die Trennwände 8 in einer konstanten Winkelteilung relativ zur Mittelachse 7 angeordnet. Weiterhin ist exemplarisch vorgesehen, dass die Trennwände 8 in einem zur Montage im Träger 4 vorgesehenen Endbereich jeweils mit benachbarten Trennwänden 8 durch Stege 9 verbunden sind, um eine Stabilisierung des Trennelements 3 zu bewirken. Dabei erstrecken sich die Stege 9 in einem radial außenliegenden Bereich der Trennwände 8 und begrenzen zusammen mit den Trennwänden 8 und der Lichtleithülse 6 jeweils fensterartige, radial innenliegende Öffnungen 10. Durch diese Öffnungen können die Lichtstrahlen von Leuchtmitteln 11 hindurchtreten, die auf der elektronischen Schaltung 5 angeordnet sind und nachstehend näher beschrieben werden.

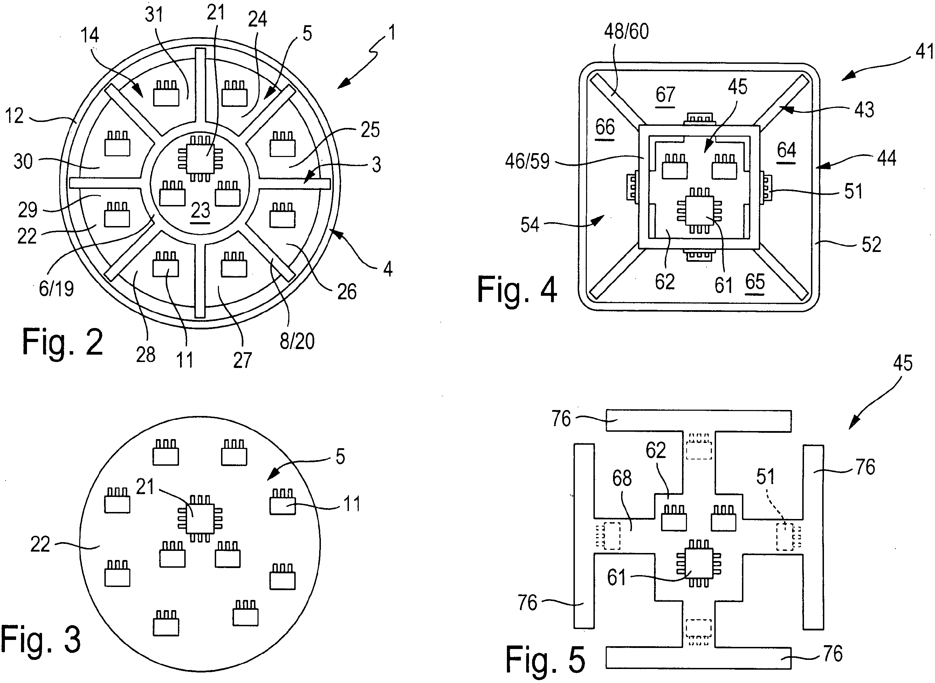

Ferner sind an dem Trennelement 3 mehrere Sensorflächen 36 ausgebildet, die exemplarisch jeweils als elektrisch leitende Beschichtung auf einander zugewandte Oberflächen benachbart angeordneter Trennwände 8 und einem die jeweiligen Trennwände 8 verbundenen Abschnitt der Außenoberfläche der Lichtleithülse 6 ausgebildet sind. Jede der Sensorflächen 36 ist nach der Montage des Trennelements 3 in den Träger 4 in nicht näher dargestellter Weise mit der elektronischen Schaltung 5 verbunden und stellt jeweils eine erste Kondensatorplatte dar. Exemplarisch ist vorgesehen, dass Außenkanten der Sensorflächen 36 parallel zu den Außenkanten der Trennwände 8 und der Lichtleithülse 6 angeordnet sind. Dabei ist die elektronische Schaltung 5 dazu ausgebildet, die erste Kondensatorplatte elektrisch aufzuladen und eine Veränderung der auf der ersten Kondensatorplatte speicherbaren Ladungsmenge zu ermitteln. Auf diesem Wege kann die elektronische Schaltung 5 eine Annäherung eines Benutzers, beispielsweise eines Fingers des Benutzers an die jeweilige Sensorfläche 36 ermitteln, da bei einer solchen Annäherung der Körper des Benutzers eine zweite Kondensatorplatte bildet, wodurch die maximal auf der ersten Kondensatorplatte speicherbare elektrische Ladungsmenge verändert wird und diese Änderung von der elektronischen Schaltung 5 als Bedienwunsch des Benutzers interpretiert werden kann, wenn die Kapazitätsänderung einen vorgebbaren Schwellwert überschreitet. Aufgrund der segmentartigen Ausgestaltung der schematisch in Figur 2 näher dargestellten Teilräume 24 bis 31 können bei der Sensoreinrichtung 1 exemplarisch bis zu neun unterschiedliche Bedienfelder ausgewertet werden, die durch die jeweiligen Sensorflächen 36 bestimmt werden. Aufgrund der orthogonalen Ausrichtung der Sensorflächen 36 zur elektronischen Schaltung 5 und im Wesentlichen auch zur Bedienoberfläche 13 werden Lichtpfade für Lichtstrahlen, die von den jeweiligen Leuchtmitteln 11 in den Teilräumen 24 bis 31 abgegeben werden, in Richtung der Mittelachse 7 und in radialer Richtung nach außen nicht behindert, so dass eine homogene Ausleuchtung des jeweiligen Teilraums 24 bis 31 und auch des dem jeweiligen Teilraum 24 bis 31 zugehörigen Bedienfelds der Abdeckung 2 gewährleistet ist.

Ergänzend oder alternativ kann vorgesehen sein, dass die elektronische Schaltung 5 für eine Nahfeldkommunikation mit einem mobilen Endgerät, insbesondere einem Mobiltelefon eingerichtet ist und hierzu wenigstens eine Spule 37 umfasst, die für eine Einkopplung und ggf. zusätzlich auch für eine Auskopplung von elektromagnetischen Wellen für diese Nahfeldkommunikation ausgebildet ist. Exemplarisch ist die Spule 37 an einem oberen Randbereich der Lichtleithülse 6 angeordnet und in nicht näher dargestellter Weise mit der elektronischen Schaltung 5 gekoppelt. Beispielsweise kann ein Benutzer ein entsprechend ausgerüstetes mobiles Endgerät, das für eine solche Nahfeldkommunikation ausgerüstet ist, an die Sensoreinrichtung 1 so annähern, dass eine vorzugsweise gering gewählte Feldstärke elektromagnetischer Wellen, die für die Nahfeldkommunikation vom mobilen Endgerät ausgesendet werden können, von der Spule 37 empfangen und an die elektronische Schaltung 5 weitergeleitet werden können. Gegebenenfalls kann auch Sensoreinrichtung 1 zum Aussenden derartiger elektromagnetischer Wellen ausgebildet sein, um beispielsweise eine Quittierung eintreffender Steuersignale, die vom mobilen Endgerät bereitgestellt werden können, zu ermöglichen. Hierzu ist die elektronische Schaltung 5 in geeigneter Weise ausgebildet, um durch Beaufschlagung der Spule 37 mit einem vorzugsweise modulierten Spulenstrom die Ausgabe von elektromagnetischen Wellen zu ermöglichen. Die Nahfeldkommunikation kann beispielsweise dazu eingesetzt werden, Einstellungen an der Sensoreinrichtung 1 vorzunehmen oder auszulesen, wobei durch die vorzugsweise geringe Feldstärke der hierbei verwendeten elektromagnetischen Wellen nur genau eine Sensoreinrichtung 1 parametriert oder analysiert werden soll.

Exemplarisch ist ferner vorgesehen, dass der napfförmige Träger 4 eine in der Figur 1 nicht sichtbare Bodenplatte und einen zirkular an der Bodenplatte angebrachten, umlaufenden Rand 12 aufweist. Der Rand 12 erstreckt sich mit einer ersten Wandstärke ausgehend von der nicht dargestellten Bodenplatte des Trägers 4 längs der Mittelachse 7. In einem der Bodenplatte abgewandten Endbereich des Randes 12 findet eine Reduzierung der Wandstärke statt, wodurch ein ringförmiger Absatz 15 gebildet wird, auf den ein korrespondierend geformter, ringförmiger Stirnbereich 16 der Abdeckung 2 aufgesetzt werden kann. Exemplarisch erstrecken sich vom Rand 12 mehrere Befestigungssockel 17 in radialer Richtung nach innen, deren axiale Stirnflächen auf dem gleichen Niveau wie der Absatz 15 liegen. Die axialen Stirnflächen der Befestigungssockel 17 sind jeweils mit einer als Bohrung ausgeführten Ausnehmung 18 versehen, in die nicht dargestellte Befestigungszapfen des Trennelements 3 eingreifen können, die an Stirnflächen der Stege 9 angebracht sind und die je nach Ausgestaltung eine formschlüssige oder kraftschlüssige Festlegung des Trennelements 3 am Träger 4 ermöglichen. Die Abdeckung 2 und der Träger 4 begrenzen ein Raumvolumen, in dem das Trennelement 3 und die Leuchtmittel 11 aufgenommen sind und das auch als Leuchtraum 14 bezeichnet wird.

Wie aus der schematischen Darstellung der Figur 2 hervorgeht, die eine schematisiert vereinfachte Darstellung der Ausführungsform gemäß der Figur 1 zeigt, sind die Lichtleithülse 6 und die Trennwände 8 mit einer konstanten Profilierung längs der Mittelachse 7 ausgeführt. Dabei ist mit Ausnahme der vorstehend beschriebenen Stege 9 in jeder parallel zur Darstellungsebene der Figur 2 ausgerichteten Querschnittsebene der gleiche Querschnitt für das Trennelement 3 verwirklicht. An einem dem Träger 4 abgewandten Endbereich ist das Trennelement abgeschrägt ausgebildet, sodass eine Stirnfläche 19 der Lichtleithülse 6 sowie Stirnflächen 20 der Trennwände 8 an eine schräg zur Mittelachse 7 ausgerichtete, gegebenenfalls sphärisch gekrümmte, Innenoberfläche der Abdeckung 2 angrenzen.

Aufgrund der Ausführung der Abdeckung 2 mit einer solchen Schrägfläche wird die Erkennbarkeit der von der Sensoreinrichtung 1 ausgebbaren Leuchtinformationen aus unterschiedlichen Raumrichtungen verbessert, wie dies insbesondere aus den Figuren 7 und 8 ersichtlich ist.

Auf der elektronischen Schaltung 5 sind die, vorzugsweise als Leuchtdioden, insbesondere als Mehrfarb-Leuchtdioden, ausgebildeten Leuchtmittel 11 elektrisch leitend angeordnet. Ferner umfasst die elektronische Schaltung 5 gemäß der Darstellung der Figur 2 eine exemplarisch als Mikrocontroller 21 ausgebildete elektronische Komponente. Elektrische Verbindungen zwischen den Leuchtmitteln 11 und dem Mikrocontroller 21 sind durch nicht näher dargestellte Leiterbahnen realisiert, die in einer gedruckten Schaltung 22 ausgebildet sind. Exemplarisch handelt es sich bei der gedruckten Schaltung 22 gemäß der Ausführungsform der Figuren 1 bis 3 um eine starre Leiterplatte oder Platine, die beispielhaft kreisrund ausgebildet ist und eine automatisierte Bestückung der Leuchtmittel 11 und des Mikrocontrollers 21 ermöglicht. Bei einer Ausführung der Leuchtmittel 11 als mehrfarbige Leuchtdioden kann durch geeignete Ansteuerung durch den Mikrocontroller 21 Licht einer einzigen Farbe oder Licht unterschiedlicher Farben oder Licht mit gemischten Farben abgegeben werden. Ferner können die Leuchtmittel 11 vom Mikrocontroller 21 vorzugsweise derart angesteuert werden, dass ihre Helligkeit variiert.

Aus der Darstellung der Figur 2 ist zu entnehmen, dass durch die Lichtleithülse und die Trennwände 8 im Leuchtraum 14 insgesamt neun Teilräume 23 bis 31 gebildet werden. Ein zentraler Teilraum 23 wird durch die Lichtleithülse 6 sowie durch die gedruckte Schaltung 22 und die Abdeckung 2 begrenzt wird. Die außenliegenden Teilräume 24 bis 31 werden durch jeweils benachbart angeordnete Trennwände 8 und die Außenoberfläche der Lichtleithülse 6 sowie durch die gedruckte Schaltung 22 und die Abdeckung 2 begrenzt. Rein exemplarisch ist vorgesehen, dass dem zentralen Teilraum 23 eine Gruppe von Leuchtmitteln, vorzugsweise zwei Leuchtmittel 11, zugeordnet sind. Die Teilräume 24 bis 31 sind jeweils exemplarisch mit einem Leuchtmittel 11 ausgestattet.

Bei der zweiten Ausführungsform einer Sensoreinrichtung 41 gemäß den Figuren 4 bis 6 ist die Lichtleithülse 46 mit einem quadratischen Querschnitt ausgebildet. Ferner ist vorgesehen, dass sich die Trennwände 48 des Trennelements 43 jeweils in Verlängerung von Diagonalen der quadratisch ausgebildeten Lichtleithülse 46 radial nach außen erstrecken und mit einer ebenfalls mit quadratischem Querschnitt ausgebildeten Abdeckung 42 in dem als Leuchtraum 54 bezeichneten Raumvolumen jeweils trapezförmige Teilräume 64 bis 67 bilden. Abweichend von der ersten Ausführungsform der Sensoreinrichtung 1 gemäß den Figuren 1 bis 3 ist bei der Sensoreinrichtung 41 vorgesehen, dass die Leuchtmittel 51, die in den äußeren Teilräumen 64 bis 67 angeordnet sind, jeweils an einer Außenoberfläche der längs einer Mittelachse 47 mit konstanter Profilierung erstreckten Lichtleithülse 46 angebracht werden.

Beispielsweise wird eine derartige Anbringung vorgesehen, um eine gezielte Abstrahlung in eine Raumrichtung für das jeweilige Leuchtmittel 51 zu bewirken. Um diese Anbringung der Leuchtmittel 51 in einfacher Weise durchführen zu können, werden die Leuchtmittel 51, die zur Anbringung in den außenliegenden Teilräumen 64 bis 67 bestimmt sind, zusammen mit den übrigen Leuchtmitteln 51 und dem Mikrocontroller 61 auf einer als flexible Leiterfolie ausgebildeten gedruckten Schaltung 62 angeordnet und bilden mit dieser die elektronische Schaltung 45. Die gedruckte Schaltung 62 kann bei der Montage in den napfförmigen Träger 44 bereichsweise abgewinkelt werden, wobei zungenförmige Fortsätze 68 der gedruckten Schaltung 62 umgebogen werden können, um die Leuchtmittel 51 an der Außenoberfläche der Lichtleithülse anbringen zu können. Ferner ist vorgesehen, dass an den jeweiligen Fortsätzen 68 jeweils streifenförmig ausgebildete Sensorflächen 76 vorgesehen sind, die jeweils zumindest nahezu vollständig als elektrisch leitende Fläche ausgeführt sind und die elektrisch mit dem Mikrocontroller 61 verbunden sind. Diese Leitflächen 76 dienen als erste Kondensatorflächen und ermöglichen es der elektronischen Schaltung 45 eine Annäherung eines Benutzers an eine der jeweiligen Sensorflächen 76 zu ermitteln und hieraus Rückschlüsse auf einen Bedienwunsch des Benutzers zu ziehen.

Wie aus der Figur 6 zu entnehmen ist, weist die Abdeckung 42 in der Seitendarstellung eine Schrägfläche 69 auf, wobei die Trennwände 48 und die Lichtleithülse 46 mit ihren Stirnflächen 59, 60 an einer Innenoberfläche 70 der Abdeckung 42 anliegen. Wie bei der ersten Ausführungsform ist auch bei der zweiten Ausführungsform vorgesehen, dass die Abdeckung 42 eine teilweise Überdeckung mit dem Rand 52 des Trägers 44 aufweist, um durch nicht dargestellte Dichtmittel oder eine stoffschlüssige Verbindung oder durch Kraftschluss eine abdichtende Wirkung für den Leuchtraum 54 zu gewährleisten.

An einer Unterseite 71 des Trägers 44 ist eine elektromechanische Schnittstelle 72 ausgebildet, die zur mechanischen und elektrischen Anbindung der Sensoreinrichtung 41 an eine korrespondierend ausgeführte, nicht dargestellte Schnittstelle an einem Aktorgehäuse vorgesehen ist. Hierzu weist die Schnittstelle 72 eine im Wesentlichen T-förmige Profilierung auf, mit der ein formschlüssiger Eingriff in eine hinterschnittene Nut des nicht dargestellten Aktorgehäuses möglich ist. Ferner sind an einer Seitenfläche der Schnittstelle 72 mehrere elektrische Kontaktflächen 73 ausgebildet, mit deren Hilfe eine elektrische Verbindung mit einer ebenfalls nicht dargestellten Kontakteinrichtung des Aktors ermöglicht wird, um eine Leistungs- und Signalübertragung zwischen dem Aktor und der Sensoreinrichtung 41 zu ermöglichen.

Die schematischen Darstellungen der Figuren 7 und 8 sollen dazu dienen, die Anbringung der Sensoreinrichtung 1 an einem Aktor 32 darzustellen. Der Aktor 32 ist als elektrischer Drehantrieb ausgebildet, bei dem eine als Aktorglied dienende Abtriebswelle 33, die mit einem endseitigen Vierkantquerschnitt versehen ist, drehbar in einem Aktorgehäuse 34 aufgenommen ist. In dem Aktorgehäuse 34 sind nicht näher dargestellte elektrische Spulen angeordnet, die für eine magnetische Wechselwirkung mit ebenfalls nicht näher dargestellten, mit der Abtriebswelle verbundenen Permanentmagneten vorgesehen sind und bei geeigneter Bestromung eine Rotationsbewegung der Abtriebswelle bewirken können. An einem der Abtriebswelle 33 entgegengesetzten Endbereich des Aktorgehäuses 34 ist eine im Wesentlichen ebene Montagefläche für die Sensoreinrichtung 1 vorgesehen. In der Montagefläche ist eine T-Nut 35 ausgebildet, in die die elektromechanische Schnittstelle der Sensoreinrichtung 1 eingeschoben werden kann, wobei die elektromechanische Schnittstelle der Sensoreinrichtung 1 exemplarisch in gleicher Weise ausgebildet sein kann wie die elektromechanische Schnittstelle 72 der Sensoreinrichtung 41. Mit dem Einschieben der elektromechanische Schnittstelle der Sensoreinrichtung 1 in die T-Nut 35 wird auch eine elektrische Kopplung zwischen dem Aktor 32 und der Sensoreinrichtung 1 hergestellt, so dass beispielsweise ein Sensorsignal eines im Aktor 32 integrierten, nicht näher dargestellten Sensors an die Sensoreinrichtung 1 bereitgestellt werden kann. Das Sensorsignal wird mit Hilfe des Mikrocontrollers 21 ausgewertet, der in Abhängigkeit von einem ermittelten Sensorsignalpegel eine vorgebbare Ansteuerung der Leuchtmittel 11 der Sensoreinrichtung 1 vornimmt.

Exemplarisch ist in der Figur 7 dargestellt, dass lediglich das erste, in der Lichtleithülse 6 angeordnete Leuchtmittel angesteuert wird, um beispielsweise eine Statusanzeige für die Funktion des Aktors 32 bereitzustellen oder um einen Bedienwunsch eines Benutzers im zentralen Bereich der Bedienoberfläche 53 der Sensoreinrichtung 41 zu quittieren. In der Figur 8 erfolgt hingegen eine qualitative Anzeige einer Schwenkstellung des Drehantriebs, indem mehrere der Teilräume der Anzeigeeinrichtung 1 durch entsprechende Ansteuerung der zugehörigen Leuchtmittel beleuchtet werden. Diese Schwenkstellung des Aktors 32 kann beispielsweise ein Resultat eines entsprechenden Bedienwunschs eines Benutzers sein, wobei der Benutzer beispielsweise durch eine teilkreisförmige Wischbewegung auf der Bedienoberfläche 53 bis zu dem jeweils gewünschten Teilraum 25 bis 31 eine Vorgabe für die Aktorbewegung macht, die durch die elektronische Schaltung 45 ausgewertet wird und die anschließend durch die Ansteuerung der den jeweiligen Teilräumen 25 bis 31 zugeordneten Leuchtmittel 11 quittiert werden kann. Besonders bevorzugt ist vorgesehen, dass bei der Quittierung der Benutzereingabe zunächst für die zu aktivierenden Leuchtmittel 11 eine erste Lichtfarbe von der elektronischen Steuerung 45 vorgegeben wird und die Lichtfarbe segmentweise mit zunehmender Drehbewegung des Aktors 32 verändert wird, um einerseits den vom Benutzer gewünschten Sollzustand und andererseits den tatsächlichen Istzustand des Aktors 32 anzuzeigen.

Andere Konfigurationen für die Beleuchtung von einzelnen Teilräumen oder Gruppen von Teilräumen können vorgesehen werden.

## Patentansprüche

1. Sensoreinrichtung für eine Erfassung von manuellen Benutzereingaben, mit einem Sensorgehäuse (2, 4; 42, 44), das an einer Außenoberfläche zumindest bereichsweise als Bedienoberfläche (13; 53) ausgebildet ist und das ein Raumvolumen (14; 54) umschließt, in dem eine elektronische Schaltung (5; 45) zur kapazitiven Erfassung einer manuellen Benutzereingabe aufgenommen ist, die elektrisch mit wenigstens einer elektrisch leitend ausgebildeten Sensorfläche (36; 76) verbunden ist und die beabstandet zur Bedienoberfläche (13; 53) angeordnet ist, **dadurch gekennzeichnet, dass** die Sensorfläche (36; 76) an einem quer zwischen der elektronischen Schaltung (4; 45) und der Bedienoberfläche (13; 53) erstreckten Trennelement (3; 43) ausgebildet ist.

2. Sensoreinrichtung nach Anspruch 1, **dadurch gekennzeichnet, dass** das Trennelement (3; 43) für eine Aufteilung des Raumvolumens (14; 54) in wenigstens zwei Teilräume (24 bis 31; 63 bis 67) ausgebildet ist und dass in wenigstens einem der Teilräume (24 bis 31; 63 bis 67) ein der elektronischen Schaltung (5; 45) zugeordnetes Leuchtmittel (11) angeordnet ist.

3. Sensoreinrichtung nach Anspruch 1 oder 2, **dadurch gekennzeichnet, dass** das Trennelement (3; 43) gestaltfest ausgebildet ist und/oder zumindest nahezu lichtundurchlässig für Lichtstrahlen des Leuchtmittels (11) ausgeführt ist.

4. Sensoreinrichtung nach Anspruch 1, 2 oder 3, **dadurch gekennzeichnet, dass** die wenigstens eine Sensorfläche (36; 76) stoffschlüssig am Trennelement (3; 43) angebracht ist.

5. Sensoreinrichtung nach Anspruch 4, **dadurch gekennzeichnet, dass** die elektronische Schaltung (5; 45) wenigstens ein Kontaktmittel, insbesondere eine Kontaktfeder, umfasst, die für eine kombinierte elektrische und mechanische Kopplung des mit der Sensorfläche (36; 76) versehenen Trennelements (3; 43) ausgebildet ist.

6. Sensoreinrichtung nach einem der Ansprüche 1 bis 3, **dadurch gekennzeichnet, dass** die elektronische Schaltung (45) einen als Sensorfläche (76) ausgebildeten, einstückig angeformten und am Trennelement (43) festgelegten Schaltungsabschnitt (76) aufweist.

7. Sensoreinrichtung nach einem der vorhergehenden Ansprüche, **dadurch gekennzeichnet, dass** das Trennelement (3; 43) eine Lichtleithülse (6; 46) umfasst und dass an der Lichtleithülse (6; 46) mehrere Trennwände (8; 48) angeordnet sind, die sich ausgehend von einer Mittelachse (7; 47), insbesondere einer Symmetrieachse, der Lichtleithülse (6; 46) in radialer Richtung nach außen bis zum Sensorgehäuse (2, 4; 42, 44) erstrecken, wobei die Lichtleithülse (6; 46) und die Trennwände (8; 48) jeweils Teilräume (24 bis 31; 63 bis 67) des Raumvolumens (14; 54) voneinander trennen und wobei zumindest einem der Teilräume (24 bis 31; 63 bis 67) ein Leuchtmittel (11) auf der elektronischen Schaltung (5; 45) zugeordnet ist.

8. Sensoreinrichtung nach Anspruch 7, **dadurch gekennzeichnet, dass** an der Lichtleithülse (6; 46) und/oder an wenigstens einer der Trennwände (8; 48) eine Sensorfläche (36; 76) ausgebildet und/oder eine Spule (37) angeordnet ist.

9. Sensoreinrichtung nach einem der vorhergehenden Ansprüche, **dadurch gekennzeichnet, dass** das Trennelement (3; 43) längs einer Profilachse (7; 47) eine, insbesondere zumindest nahezu, konstante Profilierung aufweist.

10. Sensoreinrichtung nach einem der vorhergehenden Ansprüche, **dadurch gekennzeichnet, dass** das Trennelement (3; 43) mit einem Endbereich an eine schräg zur Profilachse (7; 47) ausgerichtete, insbesondere gekrümmt ausgebildete, Innenoberfläche (70) der Bedienoberfläche (13; 53) angrenzt.

11. Sensoreinrichtung nach einem der vorhergehenden Ansprüche, **dadurch gekennzeichnet, dass** Leuchtmittel (11) im Raumvolumen (14; 54) angeordnet sind, die auf einer, vorzugsweise eben ausgebildeten, gemeinsamen elektrischen Leiteranordnung (22; 62), insbesondere einer Leiterplatte oder einer flexiblen Leiterfolie, angebracht sind.

12. Sensoreinrichtung nach Anspruch 11, **dadurch gekennzeichnet, dass** die Leuchtmittel (11) zusammen mit der Leiteranordnung (22; 62) zugeordneten elektronischen Komponenten (21; 61) eine elektronische Schaltung (5; 45) bilden, die für eine gezielte Ansteuerung der Leuchtmittel (11) in Abhängigkeit von einer Benutzereingabe an wenigstens einer Sensorfläche (36; 76) ausgebildet sind.

13. Sensoreinrichtung nach Anspruch 12, **dadurch gekennzeichnet, dass** die elektronische Schaltung (5; 45) für eine Ansteuerung der Leuchtmittel (11) nach vorgebbaren Mustern, insbesondere in der Art einer Segmentanzeige, ausgebildet ist und/oder dass zumindest eines der Leuchtmittel (11) für eine vorgebbare Abgabe von verschiedenfarbigen Lichtstrahlen ausgebildet ist.

14. Sensoreinrichtung nach Anspruch 12 oder 13, **dadurch gekennzeichnet, dass** die elektronische Schaltung (5; 45) für eine kapazitive Nahfeldkommunikation mit einer benutzergeführten Aktivierungseinheit ausgebildet ist.

15. Sensoreinrichtung einem der vorhergehenden Ansprüche, **dadurch gekennzeichnet, dass** die Sensorfläche (36; 76) zumindest im Wesentlichen quer zu einer Haupterstreckungsebene der elektronischen Schaltung (5; 45) und/oder zumindest im Wesentlichen quer zu einer Haupterstreckungsebene der Bedienoberfläche (13; 53) ausgebildet ist.
